Europäisches Patentamt

European Patent Office

Office européen des brevets

(19)

(11) EP 0 876 516 B1

(12) EUROPÄISCHE PATENTSCHRIFT

(45) Veröffentlichungstag und Bekanntmachung des Hinweises auf die Patenterteilung:
**24.05.2000 Patentblatt 2000/21**

(21) Anmeldenummer: **97901592.2**

(22) Anmeldetag: **23.01.1997**

(51) Int Cl.7: **C23C 16/28**

(86) Internationale Anmeldenummer:
**PCT/EP97/00298**

(87) Internationale Veröffentlichungsnummer:
**WO 97/27345 (31.07.1997 Gazette 1997/33)**

(54) **VERFAHREN ZUR HERSTELLUNG VON VERSCHLEISSFESTEN BORIDSCHICHTEN AUF METALLISCHEN WERKSTOFFOBERFLÄCHEN**

PROCESS FOR PRODUCING WEAR-RESISTANT BORIDE LAYERS ON METAL MATERIAL SURFACES

PROCEDE POUR PRODUIRE DES COUCHES DE BORURE RESISTANTES A L'USURE SUR DES SURFACES DE MATERIAUX METALLIQUES

(84) Benannte Vertragsstaaten:
**AT BE CH DE DK FR GB IT LI NL**

(30) Priorität: **25.01.1996 DE 19602639**

(43) Veröffentlichungstag der Anmeldung:
**11.11.1998 Patentblatt 1998/46**

(73) Patentinhaber: **BorTec GmbH**
**50354 Hürth (DE)**

(72) Erfinder:
• **HUNGER, Hans-Jörg**
**D-50169 Kerpen (DE)**
• **LÖBIG, Gunter**
**D-09112 Chemnitz (DE)**
• **TRUTE, Gerhard**
**D-50170 Kerpen (DE)**

(74) Vertreter: **Meyers, Hans-Wilhelm, Dr.Dipl.-Chem. Patentanwälte**
**von Kreisler-Selting-Werner**
**Postfach 10 22 41**
**50462 Köln (DE)**

(56) Entgegenhaltungen:
**US-A- 3 677 799**

• **THIN SOLID FILMS, Bd. 192, Nr. 2, 15.November 1990, CH, Seiten 235-251, XP000162459 CHOLET V ET AL: "LOW TEMPERATURE BORON COATINGS BY MICROWAVE PLASMA ASSISTED CHEMICAL VAPOUR DEPOSITION"**
• **PATENT ABSTRACTS OF JAPAN vol. 096, no. 002, 29.Februar 1996 & JP 07 286254 A (SUMITOMO METAL IND LTD), 31.Oktober 1995,**
• **METALLURGICAL TRANSACTIONS A (PHYSICAL METALLURGY AND MATERIALS SCIENCE), OCT. 1970, USA, Bd. 1, Nr. 10, ISSN 0360-2133, Seiten 2875-2880, XP002030195 COCHRAN A A ET AL: "Boron and boron carbide coatings by vapor deposition"**

EP 0 876 516 B1

**Beschreibung**

Die Erfindung betrifft ein Verfahren zur Herstellung von verschleißfesten Boridschichten auf metallischen Werkstoffoberflächen.

Die Erzeugung verschleißfester Boridschichten erfolgt in der Praxis meist unter Verwendung fester Boriermittel beispielsweise in Form von Pulvern, Pasten oder Granulaten.

Diese Verfahren erfordern nachteiligerweise einen hohen Arbeitsaufwand beim Einpacken, Auspacken und Reinigen der Teile. Das Reinigen erfolgt mittels einer Kombination von Waschen und Bürsten oder Strahlen. Da die Pulver, Pasten und Granulate nur einmal verwendbar sind, entstehen Probleme auch bei der Entsorgung der verbrauchten Boriermittel.

Daneben ist auch die Verwendung flüssiger Boriermittel, beispielsweise in Form von Salzschmelzen bekannt. Alle diese Verfahren haben sich jedoch auf Grund der mit Salzbädern generell verbundenen Probleme bezüglich Handhabungssicherheit, Reinigung der Teile nach der Behandlung und Entsorgung der Bäder bzw. deren Abprodukte nicht durchsetzen können.

In der Vergangenheit hat es verschiedene Versuche zum Borieren mit gasförmigen Boriermitteln gegeben (CVD-Verfahren). Bei der Verwendung organischer Borverbindungen (Bortrimethyl, Bortrialkyl) erfolgte vorwiegend eine Aufkohlung statt Borierung und bei Verwendung von Diboran treten sicherheitstechnische Probleme wegen der extremen Giftigkeit und der Explosionsgefahr auf.

Die Verwendung von Bortrichlorid als Borspendermedium konnte sich aufgrund verfahrensimmanenter Probleme bei der Schichtbildung nicht durchsetzen. Ursache dieser Probleme ist die bei der Borierung in $BCl_3$-$H_2$-Gemischen stets auftretende Chlorwasserstoffbildung.

Bei der Borierung von Eisenbasiswerkstoffen mit Bortrichlorid laufen folgende grundlegende Reaktionen ab:

$$2BCl_3 + 3H_2 + 2Fe \rightarrow 2FeB + 6HCl$$

$$2BCl_3 + 3H_2 + 4Fe \rightarrow 2Fe_2B + 6HCl$$

Das bei der Borierung mit $BCl_3$ entstehende Chlorwasserstoffgas reagiert mit dem Eisen des Grundwerkstoffes unter Bildung leicht flüchtiger Eisenchloride:

$$2HCl + Fe \rightarrow FeCl_2$$

Die Eisenchloride besitzen bei den zur Anwendung kommenden Behandlungstemperaturen im Bereich von 500°C - 1200°C hohe Dampfdrucke, so daß es zu einer dauernden starken Abdampfung von Eisenchlorid kommt. Das führt zu einer Lochbildung zwischen Boridschicht und Grundmaterial, wie sie beim $BCl_3$-Verfahren stets bemängelt wird. Eine Unterdrückung der Lochbildung ist nur möglich, wenn es gelingt, beim Beginn der Borierung innerhalb kürzester Zeit eine dicht schließende Boridschicht zu erzeugen. Das ist verfahrenstechnisch derart schwierig, daß es bis heute nicht zuverlässig und reproduzierbar gelingt.

Neben der rein thermischen Variante des CVD-Borierens sind auch Bemühungen bekannt mit Plasmaunterstützung zu borieren (PACVD-Borieren). Hier wurden bisher nur Diboran und Bortrichlorid eingesetzt, mit den bereits von der thermischen CVD her bekannten Nachteilen. Eine Zusammenstellung über die genannten Verfahren findet sich in dem Review "Engineering the Surface with Boron Based Materials", Surface Engineering 1985, Vol. 1, Nr. 3, S. 203-217.

Thin Solid Films, Bd.192, Nr. 2, 15.11.1990, CH, Seiten 235-251, Cholet V et al.: "Low Temperature Boron Coatings by Mircowave Plasma Assisted Chemical Vapour Deposition" beschreibt ein Verfahren zur mikorwellenunterstützten Plasmaabscheidung von Bor, u. a. auf Metallflächen, z.B. Stahl, Superlegierungen und Hartmetallen. Als Reaktionsgas wurde $BBr_3$ in Mischung mit Wasserstoff eingesetzt, wobei Volumenverhältnisse $H_2/BBr_3$ zwischen 5 und 100 (entsprechend ca. 83,3 - 99 Vol.% $H_2$ in der Gesamtmischung) untersucht wurden. Die Behandlungszeit betrug 1 h bei einer Abscheidungstemperatur von 550°C.

Die englischsprachige Zusammenfassung von JP-A-286 254 in Patent Abstracts of Japan offenbart $BF_3$ als Borierungsmittel für Stahloberflächen. Sie offenbart keine Plasmaunterstützung.

Aus US-A-3 677 799 ist die plasmaunterstützte Dampfphasenabscheidung von Bor u.a. auf metallischen Oberflächen bekannt. Als Reaktionsgas kann u. a. $BF_3$ in Mischung mit Wasserstoff verwendet werden, wobei molare Verhältnisse von B/H zwischen ca. 1:2 bis ca. 1:5, bevorzugt ca. 1:3 offenbart werden, entsprechend ca. 17-33 vol.%, bevorzugt 25 vol.% Borhalogenid. Die in US-A-3 677 799 vorgeschlagenen Drücke liegen zwischen atmosphärischem Druck und 3 atm. Es geht aus US-A-3 677 799 ferner hervor, daß bei Drücken, die wesentlich unter Atmosphärendruck liegen, die Borabscheidung übermäßig langsam wird.

Aufgabe der Erfindung war es, ein Verfahren zur Herstellung verschleißfester Boridschichten auf metallischen Werkstoffen zur Verfügung zu stellen, welches nicht mit den oben aufgeführten Nachteilen behaftet ist.

Die Aufgabe wird erfindungsgemäß gelöst durch ein Verfahren gemäß kennzeichnendem Teil von Anspruch 1.

Das Reaktionsgas kann zusätzlich als Borträger Bortrichlorid enthalten.

Vorzugsweise enthält das Reaktionsgas 5 bis 20 Vol.% Borhalogenid besonders bevorzugt 5 bis 15 Vol.% Borhalogenid.

Vorzugsweise enthält das Reaktionsgas 20 bis 90 Vol.% $H_2$ besonders bevorzugt 20 bis 50 Vol.% $H_2$.

Das Reaktionsgas wird dem Behandlungsraum in einer Menge von vorzugsweise 0,5 bis 2 l pro Minute besonders bevorzugt etwa 1 l/min zugeführt.

Die Borierung erfolgt im Druckbereich von 1-10 mbar unter Einfluß einer Plasmaentladung, wie sie z.B. aus Anlagen zur Plasmabeschichtung bekannt ist. Die Plasmaentladung kann gepulst oder auch ungepulst sein.

Die erforderlichen Behandlungstemperaturen von 400°C bis 1200°C, besonders bevorzugt 850 bis 950°C werden durch das Plasma selbst, oder, vor allem im Hochtemperaturbereich über 900°C, mit Unterstützung einer Zusatzheizung erzeugt.

Vorzugsweise liegt die Behandlungszeit zwischen 30 und 240 min, besonders bevorzugt zwischen 30 und 120 min.

Die Dicke der Boridschichten wird üblicherweise über die Behandlungszeit gesteuert, wobei mit zunehmender Behandlungszeit auch die Schichtdicken zunehmen.

Als weitere Gase kann das Reaktionsgas noch Argon und/oder Stickstoff enthalten. Durch sie läßt sich die Aktivität des Borüberganges steuern und eine ausreichende Erwärmung der Proben durch das Plasma erreichen. Die Zusammensetzung des Reaktionsgases kann somit je nach Behandlungsbedingungen und zu borierendem Werkstoff in weiten Grenzen variieren.

Das erfindungsgemäße Verfahren eignet sich insbesondere zur Borierung von Eisenwerkstoffen.

Bei dem erfindungsgemäßen Verfahren wird mittels Plasmaentladung der im Reaktionsgas enthaltene molekulare Wasserstoff in atomaren Wasserstoff überführt. Der atomare Wasserstoff reduziert das Borhalogenid $(BY_3)$ und ermöglicht damit die Borabgabe an die Werkstückoberfläche.

$$BY_3 + 3\,H \rightarrow B + 3\,HY$$

$$B + x\,Me \rightarrow Me_xB$$

Es kann aber auch zu einer Überführung des $BY_3$ in $BY_2$ durch das Plasma kommen, wobei dann folgende Reaktionen ablaufen können:

$$3\,BY_2 \rightarrow B + 2\,BY_3$$

$$B + x\,Me \rightarrow Me_xB$$

Im Anschluß an die Borierung ist es möglich, den borierten Werkstoff einer Nachbehandlung zu unterziehen, um eventuell gebildetes FeB in $Fe_2B$ umzuwandeln. Dies kann beispielsweise durch einen Glühprozeß im Anschluß an die Borierbehandlung erreicht werden, indem man die Zufuhr des Borhalogenids abbricht und das Werkstück noch eine Zeitlang auf Behandlungstemperatur hält. Die Länge dieser Diffusionsbehandlung richtet sich nach der Menge an vorhandenem FeB und beträgt üblicherweise zwischen 20-60 min.

Die Durchführung des Verfahrens kann beispielsweise in einer für die Plasma-Beschichtung geeigneten an sich bekannten Anlage erfolgen. Diese besteht im wesentlichen aus folgenden Komponenten:

Dem Vakuumrezipienten (Reaktor) zur Aufnahme der zu behandelnden Teile. Der Reaktor sollte beheizbar sein und ein Arbeiten im Temperaturbereich von 400°C bis 1200°C gestatten.

Dem Pumpsystem zur Evakuierung des Reaktors und der Einstellung des Arbeitsdruckes.

Der Gasversorgungseinheit zur Mischung und Dosierung des Reaktionsgemisches.

Der Puls-Plasma-Stromversorgung zur Erzeugung und Aufrechterhaltung der Plasmaentladung im Vakuumrezipienten, wobei die eingebrachte Leistung durch die Pulsfrequenz bzw. Pulsbreite in weiten Bereichen variiert werden kann.

Dem System für die Gasneutralisation und Entsorgung sowie dem System zur Steuerung und Überwachung der Betriebsparameter, das den Prozeßablauf steuert und überwacht.

**Beispiel 1**

Nach Einbringen einer Probe aus Stahl 100Cr6 in den Reaktor erfolgt das Aufheizen im Plasma einer Gleichstromglimmentladung konstanter Pulsfrequenz (4kHz) bei einem Druck von 10 mbar. Die Probenerwärmung erfolgt zusätzlich über die Beheizung des Reaktors, wodurch sich die Aufheizzeit verkürzt. Das Aufheizen und Abkühlen der Probe erfolgt in einem Argon-Wasserstoffgemisch 1:1. Nach Erreichen der Behandlungstemperatur von 850°C wird der Borträger Bortrifluorid so zugegeben, daß ein Reaktionsgasgemisch der Zusammensetzung 45 Vol.% Wasserstoff, 40 Vol.-% Argon und 15 Vol.-% Bortrifluorid entsteht. Das Gasgemisch wird dem Rezipienten in der Menge von 1 l/min zugeführt. Die Dauer der Plasmabehandlung beträgt 200 min.

Im metallographischen Schliff zeigt sich eine Boridschicht einer mittleren Dicke von 42 μm. Die Mikrohärte liegt bei 1800 $HV_{0,05}$. Die Schicht ist frei von FeB.

**Beispiel 2**

Nach Einbringen einer Probe aus Hastelloy B in den Reaktor erfolgt das Aufheizen im Plasma einer Gleichstromglimmentladung konstanter Pulsfrequenz (4kHz). Mittels Plasmaentladung bei 10 mbar wird die Probe auf eine Temperatur von 850°C erwärmt. Die Leistungsdichte wird über die Pulsbreite gesteuert. Die Probenerwärmung erfolgt ausschließlich über die Glimmentladung. Das Aufheizen und Abkühlen der Probe erfolgt in einem Argon-Wasserstoffgemisch 1:1. Nach Erreichen der Behandlungstemperatur wird der Bortriger Bortrifluorid so zugegeben, daß ein Reaktionsgemisch der Zusammensetzung 45 Vol.-% Wasserstoff, 45 Vol.-% Argon und 10 Vol.-% Bortrifluorid entsteht. Das Gasgemisch wird dem Rezipienten in der Menge von 1 l/min zugeführt. Die Behandlungszeit betrug 240 min.

Im metallographischen Schliff zeigt sich eine Boridschicht einer mittleren Dicke von 50 μm. Die Mikrohärte liegt bei 2400 $HV_{0,05}$.

**Patentansprüche**

1. Verfahren zur Herstellung von verschleißfesten Boridschichten auf metallischen Werkstoffoberflächen, dadurch gekennzeichnet, daß als Bortriger Bortrifluorid mit Wasserstoff und ggf. Argon und/oder Stickstoff zur Erzeugung eines Reaktionsgases, welches 1-35 Vol.% Borhalogenid enthält, gemischt wird und im so erhaltenen Reaktionsgas im Druckbereich von 1-10 mbar und bei Temperaturen von 400°C bis 1200°C mittels Plasmaentladung der molekulare Wasserstoff in atomaren Wasserstoff überführt wird und dieser das Bortrifluorid reduziert und damit ein Borübergang aus dem Plasma auf die Metalloberfläche ermöglicht wird.

2. Verfahren gemäß Anspruch 1, dadurch gekennzeichnet, daß das Reaktionsgas 20-90 Vol. % $H_2$ enthält.

3. Verfahren gemäß einem oder mehreren der Ansprüche 1 oder 2, dadurch gekennzeichnet, daß das Reaktionsgas den Behandlungsraum in einer Menge von 0,5 bis 2 l pro Minute zugeführt wird.

4. Verfahren gemäß einem oder mehreren der Ansprüche 1 bis 3, dadurch gekennzeichnet, daß es bei Temperaturen von 850 °C bis 950 °C durchgeführt wird.

5. Verfahren gemäß einem oder mehreren der Ansprüche 1 bis 4, dadurch gekennzeichnet, daß die Behandlungszeit zwischen 30 und 240 Minuten liegt.

**Claims**

1. A process for producing wear-resistant boride layers on metallic material surfaces, characterized by mixing boron trifluoride as boron source with hydrogen and possibly argon and/or nitrogen to generate a reaction gas containing trom 1 to 35% by volume of boron halide and, in the resulting reaction gas, converting the molecular hydrogen into atomic hydrogen in the pressure range of 1-10 mbar at a temperature of from 400°C to 1200°C by means of a plasma discharge so that the atomic hydrogen reduces the boron trifluoride and thus enables boron to be transferred from the plasma to the metal surface.

2. The process as claimed in claim 1, wherein the reaction gas contains 20-90% by volume of $H_2$.

3. The process as claimed in one or more of claims 1 and 2, wherein the reaction gas is fed into the treatment space in an amount of from 0.5 to 2 l per minute.

4. The process as claimed in one or more of claims 1 to 3 carried out at temperatures of from 850°C to 950°C.

5. The process as claimed in one or more of claims 1 to 4, wherein the treatment time is from 30 to 240 minutes.

**Revendications**

1. Procédé de fabrication de couches de borure résistantes à l'usure sur des surfaces de matériaux métalliques, caractérisé en ce qu'on mélange du trifluorure de bore, en tant que source de bore, avec de l'hydrogène et, le cas échéant, de l'argon et/ou de l'azote pour produire un gaz de réaction qui contient de 1 à 35 % en volume d'halogénure de bore, et dans le gaz de réaction ainsi obtenu, à une pression comprise entre 1 et 10 mbar et à des températures de 400°C à 1200°C, au moyen d'une décharge de plasma, on transforme l'hydrogène moléculaire en hydrogène atomique et celui-ci réduit le trifluorure de bore, ce qui permet ainsi un transfert du bore à partir du plasma vers la surface métallique.

2. Procédé selon la revendication 1, caractérisé en ce que le gaz de réaction contient de 20 à 90 % en volume de $H_2$.

3. Procédé selon l'une ou plusieurs des revendications 1 et 2, caractérisé en ce que le gaz de réaction est amené dans l'enceinte de traitement en une quantité de 0,5 à 2 l par minute.

4. Procédé selon l'une ou plusieurs des revendications 1 à 3, caractérisé en ce qu'on le met en oeuvre à des températures de 850°C à 950°C.

**5.** Procédé selon l'une ou plusieurs des revendications 1 à 4, caractérisé en ce que le temps de traitement est compris entre 30 et 240 minutes.